(19) Europäisches Patentamt
European Patent Office
Office européen des brevets

(11) **EP 4 095 934 B1**

(12) **FASCICULE DE BREVET EUROPEEN**

(45) Date de publication et mention
de la délivrance du brevet:
**28.02.2024 Bulletin 2024/09**

(21) Numéro de dépôt: **22166444.4**

(22) Date de dépôt: **04.04.2022**

(51) Classification Internationale des Brevets (IPC):
**H10N 30/01** $^{(2023.01)}$     **G01R 29/22** $^{(2006.01)}$

(52) Classification Coopérative des Brevets (CPC):
**G01N 23/20016; G01N 23/20033; G01N 23/2055**

(54) **DISPOSITIF ET UN PROCEDE DE DETERMINATION D'UN COEFFICIENT PIEZOELECTRIQUE EFFECTIF D'UN MATERIAU**

VORRICHTUNG UND VERFAHREN ZUR BESTIMMUNG EINES EFFEKTIVEN PIEZOELEKTRISCHEN KOEFFIZIENTEN EINES MATERIALS

DEVICE AND METHOD FOR DETERMINING AN EFFECTIVE PIEZOELECTRIC COEFFICIENT OF A MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.04.2021 FR 2103635**

(43) Date de publication de la demande:
**30.11.2022 Bulletin 2022/48**

(73) Titulaire: **Commissariat à l'énergie atomique et aux énergies alternatives 75015 Paris (FR)**

(72) Inventeur: **VAXELAIRE, Nicolas 38054 Grenoble Cedex 09 (FR)**

(74) Mandataire: **Atout PI Laplace Immeuble "Visium" 22, avenue Aristide Briand 94117 Arcueil Cedex (FR)**

(56) Documents cités:
**US-A1- 2013 207 513**

- **THERY VIRGINIE ET AL: "Effective piezoelectric coefficient measurement of BaTiO3thin films using the X-ray diffraction technique under electric field available in a standard laboratory", APPLIED SURFACE SCIENCE, ELSEVIER, AMSTERDAM, NL, vol. 351, 31 mai 2015 (2015-05-31), pages 480-486, XP029257929, ISSN: 0169-4332, DOI: 10.1016/J.APSUSC.2015.05.155**
- **BUZANOV O ET AL: "Measurement of independent piezoelectric constants of a lanthanumgallium silicate family crystals by X-ray diffraction method", 2013 JOINT EUROPEAN FREQUENCY AND TIME FORUM & INTERNATIONAL FREQUENCY CONTROL SYMPOSIUM (EFTF/IFC), IEEE, 21 juillet 2013 (2013-07-21), pages 122-125, XP032540657, DOI: 10.1109/EFTF-IFC.2013.6702088**
- **BLAGOV A E ET AL: "Measurement of piezoelectric constants of lanthanum-gallium tantalate crystal by X-ray diffraction methods", CRYSTALLOGRAPHY REPORTS, NAUKA /INTERPERIODICA, MOSCOW, RU, vol. 58, no. 1, 25 janvier 2013 (2013-01-25), pages 49-53, XP035343443, ISSN: 1063-7745, DOI: 10.1134/S1063774513010057 [extrait le 2013-01-25]**
- **LISSALDE F ET AL: "X-RAY DETERMINATION OF PIEZOELECTRIC COEFFICIENT IN LITHIUM NIOBATE", FERROELECTRICS,, vol. 14, 1 janvier 1976 (1976-01-01), pages 579-582, XP001415457,**

**Description**

L'invention se situe dans le domaine technique des mesures piézoélectriques, et plus spécifiquement celui de la détermination expérimentale de coefficients piézoélectriques. L'invention concerne un dispositif et un procédé de détermination d'un coefficient piézoélectrique transversal et longitudinal effectif d'un matériau d'un échantillon.

L'effet piézoélectrique traduit le couplage entre les effets mécaniques et les effets électriques. Certains matériaux ont la propriété de se polariser sous l'effet d'une contrainte mécanique, c'est l'effet piézoélectrique direct. Cette polarisation change de signe avec la contrainte. L'effet piézoélectrique est réversible et ainsi, ces matériaux se déforment sous l'effet d'une polarisation électrique résultant de l'application d'un champ électrique, c'est l'effet inverse.

La piézoélectricité est la capacité qu'a un matériau à se polariser sous l'action d'une contrainte (effet direct), ou à l'inverse de se déformer lorsqu'on lui applique un champ (effet inverse). Cela est dû à la présence dans le réseau cristallin d'atomes d'électronégativité différente.

La piézoélectricité d'un matériau est caractérisée par des coefficients piézoélectriques, issues d'expressions matricielles qui modélisent les propriétés électromécaniques. Le coefficient piézoélectrique le plus couramment utilisé, dij, est le rapport de la charge de surface par unité de contrainte mécanique appliquée pour l'effet direct ($\text{dij} = \frac{Di}{Tij}$) et le rapport de la déformation au champ électrique pour l'effet inverse ($\text{dij} = \frac{Sj}{Ei}$).

Les grandeurs physiques et notations associées aux équations sont rassemblées dans le tableau ci-dessous :

| Type | Symbole | Signification | Unités |
|------|---------|---------------|--------|
| Electrique | D | Induction ou déplacement électrique | $C.m^{-2}$ |
| | E | Champ électrique | $V.m^{-1}$ |
| | $\varepsilon$ | Permittivité électrique | $F.m^{-1}$ |
| Mécanique | S | Déformation relative | - |
| | T | Contrainte | $N.m^{-2}$ |
| | s | Compliance | $m^2.N$ |
| Piézoélectrique | d | Coefficients piézoélectriques | $C.N^{-1}$ (direct) ou $m.V^{-1}$ (inverse) |

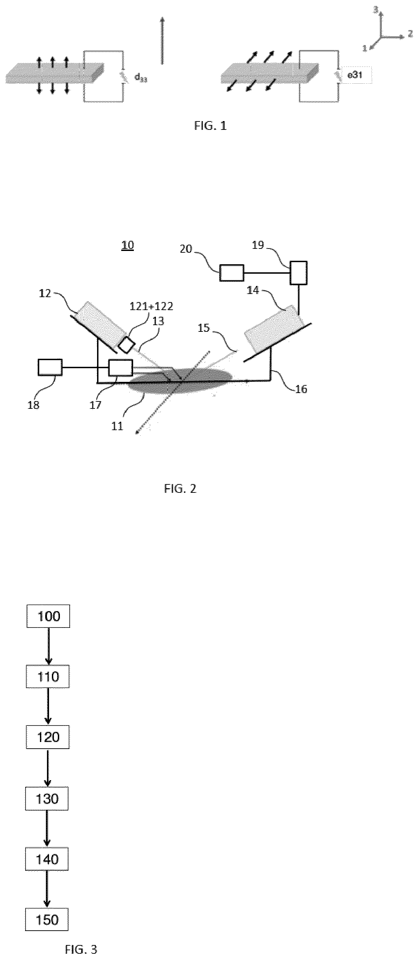

Les coefficients sont exprimés dans les formules ci-dessus avec la notation de Voigt, qui indique la direction de polarisation et la direction de la contrainte mécanique, selon les axes i et j respectivement. On distingue deux modes principaux de déformation illustrés schématiquement à la figure 1, la flèche représentant l'axe de polarisation : le mode longitudinal et le mode transversal. Dans le premier cas, les directions de polarisation et de contrainte mécaniques sont identiques (partie gauche de la figure 1) et le coefficient résultant, appelé coefficient piézoélectrique longitudinal, est noté d33. Dans le second, les directions sont perpendiculaires (partie droite de la figure 1) et le coefficient piézoélectrique, appelé coefficient piézoélectrique transversal, s'écrit e31.

Le coefficient piézoélectrique, longitudinal (d33) ou transversal (e31), est un paramètre clef dans la qualification d'un nouveau matériau, film ou procédé en vue de son intégration ultérieure dans les dispositifs actuateurs, capteurs type MEMS ou dispositifs radiofréquence (RF). Par exemple, dans les nitrures de type AIN (nitrure d'aluminium), le coefficient piézoélectrique longitudinal est faible, autour de 5 pm/V, rendant sa détermination expérimentale très délicate. Par ailleurs, d'un point de vue métrologie et contrôle de procédé, une technique de vérification de ces coefficients piézoélectriques à l'échelle d'un wafer à haut débit est souhaitable. Un exemple de l'art antérieur se trouve dans la demande de brevet US2013207513, qui utilise l'équation de Stoney pour mesurer un coefficient piézoélectrique.

L'état de l'art concernant les mesures de coefficient piézoélectrique sur film minces propose essentiellement trois solutions.

La première solution de l'art antérieur, la plus ancienne et la plus largement utilisée, est la technique dite de Berlincourt. Elle repose sur l'effet piézoélectrique direct : une force est appliquée à l'échantillon. Le coefficient d33 correspondant est déduit par la mesure de la charge électrique générée. Cette technique n'est pas très précise pour les films minces et elle est sujette à de nombreux artéfacts.

La deuxième solution proposée par l'art antérieur est connue sous l'abréviation LDV pour Laser Doppler Vibrometers. Principalement utilisée dans le cas des micro-systèmes MEMS, la technique LDV est une technique qui mesure le déplacement total du dispositif. Cette mesure est réalisée en réflexion. Ainsi, une courbure locale peut fausser le résultat.

Enfin, une troisième solution proposée par l'art antérieur est la technique d'interférométrie optique dite DBLI (pour Double Beam Laser Interferometry). A l'heure actuelle, cette technique est probablement l'approche la plus robuste pour les films minces. Ici dans un échantillon présentant une géométrie capacité MIM (Metal/Film -piézo/Metal), le déplacement total de la capacité est mesuré en fonction du bias appliqué. Le coefficient piézoélectrique est alors déduit de la courbe représentant le déplacement total en fonction du bias. Pour éviter, l'artefact lié à la courbure de la plaque, les positions inférieure et supérieure de l'échantillon sont mesurées simultanément grâce au double faisceau. Toutefois, cette technique impose l'utilisation d'échantillons nécessairement polis des deux faces pour la réflexion des deux faisceaux laser utilisés.

L'invention vise à pallier tout ou partie des problèmes cités plus haut en proposant un nouveau dispositif et procédé de détermination des coefficients piézoélectriques présentant une grande sensibilité, c'est-à-dire étant très précis, sans nécessiter le polissage des deux faces de l'échantillon ni être affecté par une courbure locale de l'échantillon.

La solution de l'invention propose ainsi une détermination précise des coefficients piézoélectriques longitudinal et transversal d'un matériau.

L'invention a pour objet un dispositif de détermination d'au moins un coefficient piézoélectrique transversal effectif sur un film mince d'un matériau d'un échantillon , caractérisé en ce qu'il comprend :

- une source de rayons X incidents sur l'échantillon;
- un détecteur de rayons X diffractés par l'échantillon;
- un dispositif de positionnement de la source de rayons X et du détecteur de rayons X par rapport à l'échantillon;
- une source de tension électrique en contact avec l'échantillon;
- un dispositif de commande de la source de tension électrique de sorte à appliquer un champ électrique à l'échantillon pendant un cycle électrique, le champ électrique générant une déformation de l'échantillon et une contrainte sur l'échantillon ;
- un dispositif de mesure d'un pic de diffraction des rayons X en fonction du champ électrique appliqué à l'échantillon pendant le cycle électrique ;
- un dispositif de traitement configuré pour déterminer le coefficient piézoélectrique transversal par l'intermédiaire de la détermination d'un rayon de courbure de l'échantillon à partir du pic de diffraction mesuré.

Selon un aspect particulier de l'invention, le dispositif comprend en outre un monochromateur et un collimateur couplés à la source de rayons X.

Selon un aspect particulier de l'invention, le détecteur de rayons X est un ensemble formé par un collimateur et un détecteur 0D ou un détecteur 1D ou 2D à pixel hybride

Selon un aspect particulier de l'invention, le dispositif de positionnement est un goniomètre comprenant au moins un premier bras mobile en rotation autour de l'échantillon et un deuxième bras, distinct du premier bras, mobile en rotation autour de l'échantillon , la source de rayons X étant positionnée sur le premier bras et le détecteur de rayons X étant positionné sur le deuxième bras.

Selon un aspect particulier de l'invention, le dispositif de détermination comprend en outre une chambre thermique dans laquelle l'échantillon est positionné.

Selon un aspect particulier de l'invention, le dispositif de détermination est configuré en outre pour déterminer un coefficient piézoélectrique longitudinal effectif. Le dispositif de traitement est configuré pour déterminer un paramètre de maille du matériau à partir du pic de diffraction mesuré et de calculer le coefficient piézoélectrique longitudinal effectif.

Selon un aspect particulier de l'invention, le dispositif de traitement est configuré pour déterminer le rayon de courbure par une courbe de basculement mesurée en une pluralité de points sur l'échantillon.

L'invention a pour objet en outre un procédé de détermination d'au moins un coefficient piézoélectrique transversal effectif sur un film mince d'un matériau d'un échantillon, caractérisé en ce qu'il comprend les étapes suivantes :

- application d'un champ électrique à l'échantillon pendant un cycle électrique ;
- émission de rayons X incidents sur l'échantillon ;
- détection de rayons X diffractés par l'échantillon ;
- mesure d'un pic de diffraction des rayons X en fonction du champ électrique appliqué à l'échantillon pendant le cycle électrique ;
- détermination d'un rayon de courbure de l'échantillon à partir du pic de diffraction mesuré
- calcul du coefficient piézoélectrique transversal effectif.

Selon un aspect particulier de l'invention, l'étape d'application d'un champ électrique comprend l'application d'une pluralité de valeurs de champ électrique, l'une parmi la pluralité de valeurs de champ électrique étant préférentiellement égale à zéro.

Selon un aspect particulier de l'invention, le procédé vise à déterminer en outre un coefficient piézoélectrique longitudinal effectif. Le procédé comprend en outre les étapes suivantes :

- détermination d'un paramètre de maille du matériau à partir du pic de diffraction mesuré,

- Calcul du coefficient piézoélectrique longitudinal effectif.

Selon un aspect particulier de l'invention, le paramètre de maille du matériau est déterminé par application de la loi de Bragg selon laquelle 2 * d-spacing * sin(θ) = λ, où λ est la longueur d'onde du faisceau de rayons X, θ est l'angle entre les rayons X incidents et les rayons X diffractés et d-spacing est le paramètre de maille.

Selon un aspect particulier de l'invention, l'étape de calcul du coefficient piézoélectrique effectif longitudinal est réalisée selon l'équation :

$$d_{33,\,eff} = (S_3/E_3)$$

où S3 est la déformation et E3 le champ électrique appliqué, à une température T préalablement définie, S3 étant calculé selon l'équation S3 = {d-spacing(E) -d-spacing(E=0)} / d-spacing(E=0), où d-spacing(E) est le paramètre de maille avec application d'un champ électrique E.

Selon un aspect particulier de l'invention, le rayon de courbure est déterminé par une courbe de basculement mesurée en une pluralité de points sur l'échantillon.

Selon un aspect particulier de l'invention, l'étape de calcul du coefficient piézoélectrique transversal effectif est réalisée selon l'équation :

$$e_{31,\,eff} = (T_1/E_3)$$

où T1 est la contrainte et E3 le champ électrique appliqué, à une température T préalablement définie, T1 étant calculé par application de la formule de Stoney.

L'invention sera mieux comprise et d'autres avantages apparaîtront à la lecture de la description détaillée d'un mode de réalisation donné à titre d'exemple, description illustrée par le dessin joint dans lequel :

[Fig.1] la figure 1 représente schématiquement des modes de déformation d'un matériau piézoélectrique longitudinal et transversal effectifs ;

[Fig.2] la figure 2 représente schématiquement un dispositif de détermination d'un coefficient piézoélectrique effectif d'un matériau d'un échantillon selon l'invention;

[Fig.3] la figure 3 représente un organigramme illustrant les étapes d'un procédé de selon l'invention ;

[Fig.4] la figure 4 représente le déplacement du pic de diffraction le long de deux cycles électriques triangulaires de +/- 50V dans un exemple d'application du procédé selon l'invention;

[Fig.5] la figure 5 représente l'évaluation du coefficient piézoélectrique longitudinal effectif d'un matériau dans un exemple d'application du procédé selon l'invention;

[Fig.6] la figure 6 représente la déformation S3 en fonction du champ électrique appliqué à l'échantillon, à température ambiante, dans un exemple d'application du procédé selon l'invention;

[Fig.7] la figure 7 représente la déformation S3 en fonction du champ électrique appliqué à l'échantillon, à une température de 100°C, dans un exemple d'application du procédé selon l'invention ;

[Fig.8] la figure 8 représente le principe de détermination d'un rayon de courbure pour la détermination d'un coefficient piézoélectrique transversal effectif du procédé selon l'invention.

Sur ces figures, dans un souci de clarté, les échelles ne sont pas respectées. Par ailleurs, les mêmes éléments porteront les mêmes repères dans les différentes figures.

La figure 1 représente schématiquement des modes de déformation d'un matériau piézoélectrique longitudinal et transversal. Elle a été présentée dans l'introduction.

La figure 2 représente schématiquement un dispositif 10 de détermination d'un coefficient piézoélectrique effectif sur un film mince d'un matériau d'un échantillon selon l'invention. Le dispositif 10 de détermination d'un coefficient piézoélectrique effectif d'un matériau d'un échantillon 11 permet de déterminer le coefficient piézoélectrique transversal e31eff et/ou longitudinal d33eff effectif sur un film mince d'un matériau. Le dispositif 10 de l'invention comprend une source 12 de rayons X incidents 13 sur l'échantillon 11 composé du matériau dont on souhaite connaître le coefficient piézoélectrique. Il comprend aussi un détecteur 14 de rayons X diffractés 15 par l'échantillon 11. En outre, le dispositif 10 comprend un dispositif de positionnement 16 de la source 12 de rayons X et du détecteur 14 de rayons X par rapport à l'échantillon 11. Le dispositif 10 comprend une source de tension électrique 17 en contact avec l'échantillon 11, ainsi qu'un dispositif de commande 18 de la source de tension électrique 17 de sorte à appliquer un champ électrique à l'échantillon 11 pendant un cycle électrique, le champ électrique générant une déformation de l'échantillon et une contrainte sur l'échantillon. Enfin, le dispositif 10 comprend un dispositif de mesure 19 d'un pic de diffraction des rayons X en fonction du champ électrique appliqué à l'échantillon 11 pendant le cycle électrique, et un dispositif de traitement 20 configuré pour déterminer le coefficient piézoélectrique (e31eff, et/ou d33eff). Le dispositif de traitement 20 sera décrit plus en détail ci-après.

Le dispositif 10 de détermination d'un coefficient piézoélectrique effectif d'un matériau d'un échantillon 11 permet de déterminer le coefficient piézoélectrique transversal e31 eff et/ou longitudinal d33eff d'un matériau en se basant sur le principe de diffraction des rayons X. L'invention repose sur une mesure très précise du paramètre de maille cristallin du matériau à caractériser le long d'un cycle électrique. Ce paramètre de maille est mesuré par diffraction des rayons X avec le dispositif 10. Cette connaissance permet après un traitement adapté de déduire le coefficient piézoélectrique effectif recherché e31 eff, d33eff.

Avantageusement, le champ électrique est appliqué par deux pointes automatiques reliées à la source de tension électrique et destinées à être connectées à l'échantillon à évaluer. Les deux pointes peuvent être par exemple amorties sur ressort pointant sur le centre du dispositif de positionnement 16. Une translation selon le plan de l'échantillon peut être incluse pour positionner ou retirer les pointes sur les zones d'intérêt. Ces pointes permettent de faire le contact électrique sur la capacité MIM (métal/isolant/métal) constituant l'échantillon.

Avantageusement, le dispositif de positionnement 16 est un goniomètre. Un goniomètre est un appareil ou un capteur servant à mesurer les angles. En optique, le goniomètre est utilisé pour déterminer la déviation d'un rayon lumineux par un dispositif optique. Le goniomètre comporte une partie fixe, sur laquelle est montée une partie mobile portant une lunette de visée. On peut avoir deux configurations : la partie fixe est liée au référentiel du laboratoire (au sol), la partie mobile pointant dans la direction dont on veut déterminer l'angle avec l'axe de référence ; ou bien la partie fixe est liée au référentiel de l'objet observé, la partie mobile pointe vers la direction de référence.

En radiocristallographie, le goniomètre est la partie du diffractomètre qui sert à déterminer les angles. Les mouvements sont motorisés.

Dans la majeure partie des cas, les angles sont déterminés par les ordres donnés aux moteurs (moteurs pas à pas) : lors de l'initialisation, l'appareil établit son zéro (par rapport à un point de référence, par exemple une encoche sur le goniomètre) ; l'angle correspondant au zéro du moteur est déterminé par une procédure d'alignement connue de l'Homme du métier.

Dans le cas d'une mesure à haute résolution, il devient très long de stabiliser la position exacte des moteurs (la boucle de rétroaction génère des oscillations qui se réduisent au fur et à mesure). Dans ce cas, il est plus intéressant (gain de temps) de laisser le moteur se placer approximativement, puis de mesurer l'angle (mesure automatique, par exemple à l'aide d'un capteur optique).

Avantageusement, le dispositif de positionnement 16 est un goniomètre comprenant au moins un premier bras mobile en rotation autour de l'échantillon 11 et un deuxième bras, distinct du premier bras, mobile en rotation autour de l'échantillon 11, la source 12 de rayons X étant positionnée sur le premier bras et le détecteur 14 de rayons X étant positionné sur le deuxième bras. Dans un autre mode de réalisation, la table support de l'échantillon peut en outre être mobile en translation dans le plan de l'échantillon pour aider au bon positionnement de l'échantillon par rapport à la source et au détecteur de rayons X.

Dans le cas le plus général, il s'agit d'un goniomètre à deux cercles, apte à déterminer l'angle d'incidence du faisceau de rayons X sur l'échantillon, et l'angle entre le faisceau incident et le faisceau détecté, pouvant être appelé $\theta$. Le terme de « cercle » désigne en fait une motorisation permettant un mouvement circulaire.

Avantageusement, le dispositif de détermination 10 selon l'invention comprend en outre un monochromateur 121 et un collimateur 122 couplés à la source 12 de rayons X. Le monochromateur 121 est un dispositif utilisé en optique pour sélectionner une gamme la plus étroite possible de longueurs d'onde à partir d'un faisceau lumineux de gamme de longueurs d'onde plus large. Pour séparer les différentes longueurs d'ondes d'un faisceau lumineux, un monochromateur peut utiliser soit le phénomène de dispersion de la lumière par un prisme, soit le phénomène de diffraction par un réseau ou par un cristal. Une fente de sortie permet de choisir la longueur d'onde voulue en fonction de sa position sur le spectre qui a été étalé par dispersion.

Le collimateur 122 est un dispositif optique permettant d'obtenir un faisceau de rayons de lumière parallèles à partir d'une source de lumière. La dispersion ou la diffraction du faisceau lumineux n'est utilisable que si la lumière est collimatée, c'est-à-dire si tous les rayons lumineux sont parallèles (ou pratiquement parallèles). Dans la pratique, les faisceaux lumineux sont presque toujours divergents, et il est nécessaire d'utiliser un collimateur 122 pour rendre les rayons parallèles.

Dans un mode de réalisation, il n'y a pas de source de flexion de l'échantillon, c'est-à-dire que l'échantillon n'est pas soumis à une déformation physique.

Dans un mode de réalisation, le détecteur 14 de rayons X est un ensemble formé par un collimateur et un détecteur 0D ou un détecteur 1D ou 2D à pixel hybride. Le détecteur 0D est un détecteur dit « ponctuel » qui mesure une intensité à travers une fenêtre d'entrée qui ne voit que les photons X provenant d'un petit angle solide donné. Le détecteur 1D est un détecteur linéaire ou courbe à une dimension qui détecte les rayons X simultanément le long d'une ligne, soit droite, soit courbe. Le détecteur 2D est un détecteur bidimensionnel, soit plat, soit cylindrique, qui donne une image pixélisée sur laquelle le contraste d'intensité correspond à des zones plus ou moins éclairées par les rayons X diffractés par l'échantillon. Un détecteur 2D à pixel hybride peut être considéré comme une matrice de centaines de milliers de détecteurs ponctuels fonctionnant en parallèle et de manière indépendante.

Dans un autre mode de réalisation, le dispositif de détermination 10 selon l'invention peut comprendre en outre une chambre thermique dans laquelle l'échantillon 11 est positionné. La chambre thermique peut être un four ou un refroidisseur et permet de placer l'échantillon à évaluer dans une atmosphère à une température contrôlée, différente de la température ambiante.

Dans le cas où le coefficient piézoélectrique à déterminer est le coefficient piézoélectrique longitudinal d33eff, le dispositif de traitement 20 est configuré pour déterminer un paramètre de maille (d-spacing) du matériau à partir du pic de diffraction mesuré et de calculer le coefficient piézoélectrique longitudinal effectif d33eff.

Dans le cas où le coefficient piézoélectrique à déterminer est le coefficient piézoélectrique transversal e31eff, le dispositif de traitement 20 est configuré pour déterminer le rayon de courbure par une courbe de basculement mesurée en une pluralité de points sur l'échantillon. On peut noter que le dispositif de traitement 20 peut être configuré pour à la fois déterminer un paramètre de maille (d-spacing) du matériau à partir du pic de diffraction mesuré et de calculer le coefficient piézoélectrique longitudinal effectif d33eff et déterminer le rayon de courbure par une courbe de basculement mesurée en une pluralité de points sur l'échantillon.

La figure 3 représente un organigramme illustrant les étapes d'un procédé de détermination d'un coefficient piézoélectrique transversal e31eff et/ou longitudinal d33eff effectif sur un film mince d'un matériau d'un échantillon selon l'invention. Le procédé comprend les étapes suivantes :

- application (étape 100) d'un champ électrique à l'échantillon pendant un cycle électrique ;
- émission (étape 110) de rayons X incidents sur l'échantillon ;
- détection (étape 120) de rayons X diffractés par l'échantillon ;
- mesure (étape 130) d'un pic de diffraction des rayons X en fonction du champ électrique appliqué à l'échantillon pendant le cycle électrique ;
- détermination (étape 140) d'un paramètre de maille du matériau à partir du pic de diffraction mesuré ou d'un rayon de courbure de l'échantillon à partir du pic de diffraction mesuré;
- calcul (étape 150) du coefficient piézoélectrique effectif.

Dans ce qui suit, le procédé de détermination d'un coefficient piézoélectrique effectif d'un matériau d'un échantillon selon l'invention est détaillé dans le cas du coefficient piézoélectrique longitudinal d33eff. Toutefois, le même principe s'applique au coefficient piézoélectrique transversal e31eff, de façon analogue qu'un Homme du métier saura appliquer sur la base de la description faite ici.

Tout d'abord, l'échantillon du matériau dont on souhaite connaître le coefficient piézoélectrique longitudinal, par exemple sous forme de wafer ou de coupon, est placé au centre du dispositif de détermination 10 sur la table support, soit avec un robot soit manuellement.

Ensuite, lors de l'étape 100, un champ électrique est appliqué à l'échantillon pendant un cycle électrique. Par exemple, il est possible d'avoir recours à des points de touches que l'on positionne pour appliquer la différence de potentiel entre une électrode inférieure et une électrode supérieure de l'échantillon. Alternativement, si l'échantillon est un substrat de silicium Si dopé, l'élément de préhension peut être mis à la masse, et il n'y a pas nécessité d'avoir une électrode inférieure déposée. Dans une autre alternative, dans laquelle une électrode inférieure n'est pas nécessaire, il est possible de faire des mesures sur deux plots déposés sur l'échantillon.

Avantageusement, l'étape 100 d'application d'un champ électrique comprend l'application d'une pluralité de valeurs de champ électrique, l'une parmi la pluralité de valeurs de champ électrique étant préférentiellement égale à zéro (pour permettre l'étalonnage du dispositif, c'est-à-dire quand aucun champ électrique n'est appliqué). Pour un matériau piézoélectrique ferroélectrique, le champ appliqué ne doit pas dépasser le champ coercitif du matériau.

Simultanément, les étapes 110 (émission de rayons X incidents sur l'échantillon) et 120 (détection de rayons X diffractés par l'échantillon) ont lieu.

Il s'en suit l'étape 130 de mesure d'un pic de diffraction des rayons X en fonction du champ électrique appliqué à l'échantillon pendant le cycle électrique. Pour déterminer le paramètre de maille, appelé ici d-spacing, du matériau le principe de la diffraction est utilisé. La mesure est basée sur des jauges locales de déformation que sont les cristallites (ou domaines cohérents de diffraction) qui contribuent au signal de diffraction. Ces cristallites sont petites (de l'ordre de 50 -100 nm), ainsi leur mesure permet de s'affranchir des effets de courbure. Ces effets de courbures sont prédominants dans le cas des films minces et rendent difficile la mesure de coefficients piézoélectrique fiable.

Pour chaque tension électrique appliquée le long d'un cycle électrique, un pic de diffraction est mesuré (étape 130). Avantageusement, la source de tension est synchronisée avec le détecteur de rayons X. La mesure peut être quasi-statistique DC ou en alternatif AC.

Avantageusement, le pic de diffraction est ajusté afin de déterminer avec précision le paramètre de maille du matériau en fonction du champ électrique (étape 140).

La courbe de déformation en fonction du champ électrique appliqué, S33(E), est finalement ajustée par une droite (étape 150). La pente de la droite donne le coefficient piézoélectrique d33eff recherché.

Plus précisément, en partant des équations fondamentales de la piézoélectricité, on a :

$$S = s*T + d*E$$

et

$$D = \varepsilon*E + d*T$$

avec les grandeurs physiques définies dans l'introduction.

L'équation fondamentale de la piézoélectricité S = s*T+ d*E s'écrit alors sous forme matricielle:

$$\begin{pmatrix} S_1 \\ S_2 \\ S_3 \\ S_4 \\ S_5 \\ S_6 \end{pmatrix} = \begin{pmatrix} s_{11} & s_{12} & s_{13} & 0 & 0 & 0 \\ s_{12} & s_{11} & s_{13} & 0 & 0 & 0 \\ s_{13} & s_{13} & s_{33} & 0 & 0 & 0 \\ 0 & 0 & 0 & s_{44} & 0 & 0 \\ 0 & 0 & 0 & 0 & s_{44} & 0 \\ 0 & 0 & 0 & 0 & 0 & s_{66} \end{pmatrix} \begin{pmatrix} T_1 \\ T_2 \\ T_3 \\ T_4 \\ T_5 \\ T_6 \end{pmatrix} + \begin{pmatrix} 0 & 0 & d_{31} \\ 0 & 0 & d_{31} \\ 0 & 0 & d_{33} \\ 0 & d_{15} & 0 \\ d_{15} & 0 & 0 \\ 0 & 0 & 0 \end{pmatrix} \begin{pmatrix} E_1 \\ E_2 \\ E_3 \end{pmatrix}$$

Soit sous forme développée :

$$S_1 = s_{11}\,T_1 + s_{12}\,T_2 + s_{13}\,T_3 + d_{31}\,E_3$$

$$S_2 = s_{12}\,T_1 + s_{11}\,T_2 + s_{13}\,T_3 + d31\,E_3$$

$$S_3 = s_{13}\,T_1 + s_{13}\,T_2 + s_{33}\,T_3 + d33\,E_3$$

$$S_4 = s_{44}\,T_4 + d15\,E_2$$

$$S_5 = s_{44}\,T_5 + d15\,E_1$$

$$S_6 = s_{66}\,T_6$$

Ainsi si on ajoute les hypothèses relatives aux films minces :

T1 =T2 (contrainte bi-axiale isotrope, effet de symétrie)
T3 = 0 : surface libre (puisque la surface de l'échantillon est libre, il n'y a pas de contrainte sur la direction hors plan)
S1= S2 = 0 car le film est accroché à son substrat rigide (dans le cas d'un film clampé sur son substrat beaucoup plus épais, il n'y a pas de déformation sur les axes 1 et 2).

Et si on applique un champ selon l'axe z, E= (0, 0, E3), on obtient :

$$0 = (s_{11} + s_{12})\, T_1 + d31\, E_3$$

$$S_3 = 2s_{13}\, T_1 + d33\, E_3$$

On trouve la définition du coefficient effectif d33eff:

$$T_1 = -\frac{d31}{s_{11}+s_{12}} E_3$$

$$S_3 = \left(d33 - 2*d31\frac{s_{13}}{s_{11}+s_{12}}\right) E_3 = d_{33,\text{eff}}\, E_3$$

Ainsi, d33,eff = E3/S3.

La méthode de diffraction décrite consiste à mesurer S3 en fonction de E3. Ainsi, en affinant le coefficient directeur de la droite, on obtient expérimentalement le coefficient longitudinal effectif d33eff.

Puis on obtient la relation définissant le coefficient piézoélectrique longitudinal effectif qui est celui dans la pratique déterminé d33eff:

$$d_{33,\text{eff}} = (S_3/E_3)/T$$

où S3 est la déformation et E3 le champ électrique appliqué, à une température T préalablement définie, S3 étant calculé selon l'équation S3 = {d-spacing(E) -d-spacing(E=0 V/pm)} / d-spacing(E=0 V/$\mu$m), où d-spacing(E) est le paramètre de maille avec application d'un champ électrique E.

Le paramètre de maille (d-spacing) du matériau est déterminé par application de la loi de Bragg selon laquelle 2 * d-spacing * sin($\theta$) = $\lambda$, où $\lambda$ est la longueur d'onde du faisceau de rayons X, $\theta$ est l'angle entre les rayons X incidents et les rayons X diffractés et d-spacing est le paramètre de maille.

La détermination d'un coefficient piézoélectrique selon l'invention repose sur la diffraction des rayons X. Cette combinaison d'étapes de diffraction et de détermination de paramètre de maille permet de mesurer très précisément la déformation S3, via une mesure du paramètre de maille du cristal dans la direction du champ électrique E3. Ainsi, la pente de la courbe S3(E) est déterminée expérimentalement et correspond par définition au coefficient piézoélectrique longitudinal effectif recherché.

Il en résulte une grande sensibilité absolue dans la détermination du coefficient piézoélectrique. Selon les cas, la précision dans la détermination du coefficient peut aller jusqu'au dixième de pm/V. De faibles coefficients (donc des variabilités) piézoélectriques peuvent être mesurés. La mesure est basée sur une mesure de déformation locale moyennée avec une large statistique (cristallites utilisées comme jauge de déplacement). Contrairement aux solutions de l'art antérieur, le procédé de l'invention n'est pas base sur un déplacement macroscopique qui est, par nature, sujet à plus de dérives expérimentales.

Le dispositif selon l'invention permet de s'affranchir des courbures locales des échantillons qui ont pour conséquence de fausser les valeurs de coefficients piézoélectriques obtenus.

L'invention présenté également l'avantage que les échantillons ne doivent pas être nécessairement polis des deux faces. Ce double polissage est contraignant et nécessaire pour la réflexion des deux faisceaux laser utilisés dans la solution DBLI de l'art antérieur.

De plus, les alignements des échantillons sont simples contrairement aux alignements requis par la solution DBLI de l'art antérieur. Il en résulte une possibilité de grande automatisation possible avec des mesures multiples possibles sur de grandes zones d'intérêts.

Par la suite, des résultats issus de la mise en oeuvre du dispositif et procédé de détermination de coefficients piézoélectriques selon l'invention sont présentés.

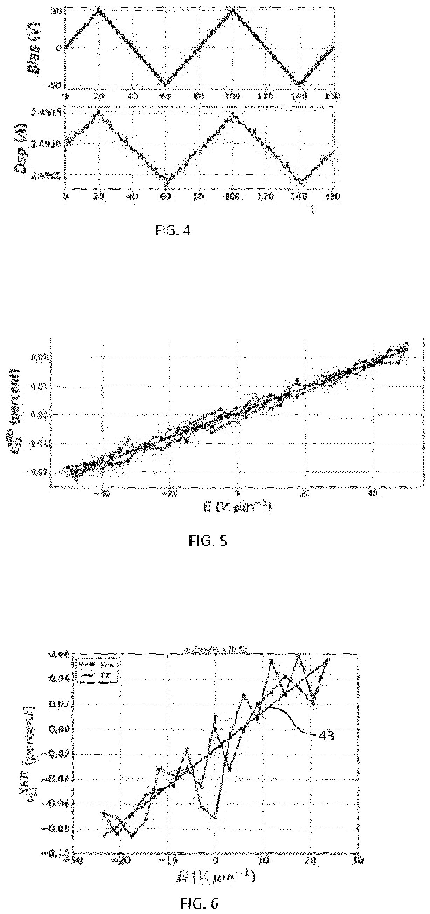

La figure 4 représente le déplacement du pic de diffraction le long de deux cycles électriques triangulaires de +/- 50V dans un exemple d'application du procédé selon l'invention.

**EP 4 095 934 B1**

Le dispositif et le procédé de l'invention a été validé sur un échantillon modèle. L'échantillon est un film mince d'AlN (nitrure d'aluminium) de 1 μm d'épaisseur (utilisé par exemple dans des applications radiofréquence). Comme détaillé précédemment, une tension électrique est appliquée entre une électrode inférieure et supérieure (géométrie Metal/Isolant/Metal ou MIM). Ici une électrode rectangulaire de 2x8 mm² de surface est considérée. Ici, deux cycles de +-50V successifs ont été appliqués (haut de la figure 4) pour vérifier l'absence de dérive. Pour chacune des tensions, le pic (002) de l'AlN a été mesuré par diffraction des rayons X dans une géométrie coplanaire symétrique (bas de la figure 4) en utilisant des optiques de haute résolution. Dans cette géométrie, le coefficient piézoélectrique longitudinal d33eff est déduit de la courbe e33(E) comme décrit précédemment. Une valeur de 4,36 pm/V est obtenue. Cette valeur est comparable à celle de la littérature obtenue par la technique d'interférométrie optique dite DBLI.

L'obtention du coefficient piézoélectrique longitudinal d33eff repose sur la faculté d'obtenir un paramètre de maille d-spacing très précis. Cette évaluation sera d'autant plus précise que le pic de diffraction présentera une largeur FWHM faible (par rapport au déplacement du pic attendu lors de l'application du champ électrique). FWHM est l'abréviation du terme anglo-saxon « full width at half maximum » signifiant largeur à mi-hauteur, qui correspond à la largeur à mi-hauteur du maximum du pic, qui est une expression de la largeur d'une fonction. Pour se faire, des optiques de haute résolution sont recommandées. Ici, de manière avantageuse mais non obligatoire pour l'application de l'invention, un miroir multicouche collimatant, suivi d'un monochromateur type Bartel-asymétrique sont utilisés en sortie de tube émetteur de rayons X. Un détecteur 1D en mode statique est utilisé pour la mesure après un alignement standard et positionnement des deux pointes de touches reliant la capacité à la source de tension électrique externe. Les mesures de rayons X sont alors synchronisées avec la source de tension électrique qui délivre les tensions préalablement choisies.

La largeur FWHM du pic AlN(002) dépend de la taille du faisceau en sortie de monochromateur. Sachant que le pic AlN(002) va se déplacer de 0.007° entre E= 0 et 50V/μm, une largeur instrumentale de 0.064° soit un choix de faisceau de 200 μm, est pertinent, car l'affinement est précis à quelques fractions de la largeur du pic.

Concernant la durée de mesure, un film d'AlN texturé 002 (type de film courant dans les applications) a été utilisé. Les mesures sont réalisées telles que décrites précédemment. Le film d'AlN fait 1μm d'épaisseur, il est texturé (002) avec une mosaïcité de 1.5°. Il a été constaté qu'une mesure de comptage de 5 secondes est suffisante pour obtenir un pic de diffraction adéquate. Compte tenu des temps de latence du détecteur, une mesure toute les 12 secondes est possible. Comme il faut un minimum de 5 points en bias, i.e. 0V,+40V,+50V,-40V,-50V, on obtient une durée de mesure totale de 60 secondes (12s par scan, avec 5 points, c'est-à-dire 12*5= 60s) nécessaire pour obtenir le coefficient d33eff de l'AlN dans ce cas.

Cette durée d'une minute est tout à fait compatible avec une approche métrologie in-line pour qualifier des plaques et la mesure de nombreux points de contrôle. Il est bien sûr possible d'augmenter les durées de mesure et le nombre de points en tension pour améliorer la précision de la mesure.

La figure 5 représente l'évaluation du coefficient piézoélectrique longitudinal d'un matériau dans un exemple d'application du procédé selon l'invention. Il s'agit de la courbe de déformation en fonction du champ électrique appliqué, S33(E). Cette courbe est ajustée par une droite (étape 150). La pente de la droite donne le coefficient piézoélectrique d33eff recherché.

La figure 6 représente la déformation S3 en fonction du champ électrique appliqué à l'échantillon, à température ambiante, dans un exemple d'application du procédé selon l'invention.

La détermination du coefficient piézoélectrique longitudinal d33eff est décrite ici dans le cas d'un film mince de co-polymère ferroélectrique P(VDF, TrFe). Une capacité MIM composée d'électrodes conductrices et d'un film de P(VDF, TrFe) de 2μm d'épaisseur est déposée sur une lame de verre.

Une mesure du pic de diffraction vers 2θ = 20° (pour une source de rayons X au Cu de 1.54056 Angstrom, soit 0.154056 nm) et de son évolution en fonction du champ électrique appliqué permet, comme précédemment décrit, d'évaluer la pente de la courbe S33(E) (référencée 43) de la figure 6. Dans le cas présent, un coefficient piézoélectrique longitudinal d33eff égal à 29.9 pm/V est obtenu à température ambiante.

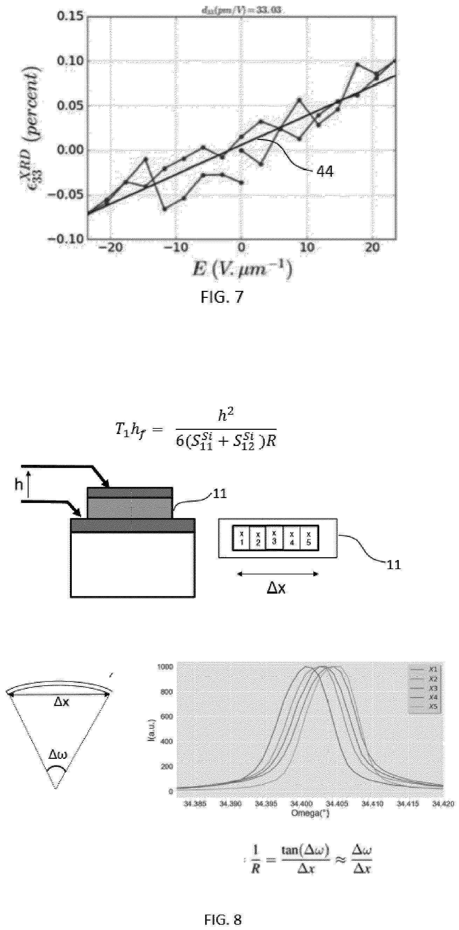

La figure 7 représente la déformation S3 en fonction du champ électrique appliqué à l'échantillon, à une température de 100°C, dans un exemple d'application du procédé selon l'invention.

L'invention permet également de mesurer ce coefficient à différentes températures moyennant l'ajout d'une chambre thermique (four ou refroidisseur) dans le dispositif de l'invention pour y placer l'échantillon. Pour démontrer la faisabilité d'une telle détermination, le même échantillon sous forme de film mince de co-polymère ferroélectrique P(VDF, TrFe) a été utilisé et placé dans un four à 100°C. Le procédé de détermination de l'invention permet de déterminer, par détermination de la pente de la courbe référencée 44, un coefficient piézoélectrique longitudinal d33eff égal à 33.03 pm/V à T = 100°C. Ces données sont en accord avec les valeurs connues.

Le dispositif et procédé selon l'invention permet l'évaluation des propriétés piézoélectriques en température avec une plage d'application compatible du domaine automobile (entre -30°C et +80°C) ou encore à plus basse ou plus haute température pour le domaine de la défense, l'aéronautique et le spatial. L'invention permet également des approches de type métrologie adaptées à l'industrie microélectronique avec un contrôle du coefficient piézoélectrique e31eff, d33eff sur substrat en silicium en ligne puis en procédant à une cartographie x,y.

9

Dans le cas où le coefficient piézoélectrique à déterminer est le coefficient piézoélectrique transversal e31eff, le rayon de courbure est déterminé par une courbe de basculement mesurée en une pluralité de points sur l'échantillon. Lors de l'étape 130, les rayons sont diffractés du substrat ou de la couche piézoélectrique en fonction du coefficient calculé. La détermination de la courbe de basculement (aussi connue sous son terme anglo-saxon « rocking curve ») est réalisée en au moins trois points (on regarde les rayons diffractés par le substrat).

On peut noter que le rayon de courbure peut être mesuré alternativement par laser ou vibromètre.

La seconde équation fondamentale de la piézoélectricité donne :

$$\begin{cases} T_p = c_{pq}^E S_q - e_{kp}E_k \\ D_i = e_{iq}S_q + c_{ik}^S E_k \end{cases}$$

Avec les mêmes hypothèses du film mince clampé sur son substrat rigide que précédemment, on obtient (e31,f dans les équations ci-dessous correspondant au coefficient e31eff) :

$$S_3 = \frac{e_{33}}{c_{33}^E}E_3$$

$$T_1 = T_2 = \frac{c_{13}^E}{c_{33}^E}e_{33}E_3 - e_{31}E_3 = e_{31,f}E_3$$

$$e_{31,f} = e_{31} - \frac{c_{13}^E}{c_{33}^E}e_{33}$$

(On peut noter que l'on peut aussi exprimer e31 eff avec le coefficient d31 :

$$e_{31,f} = \frac{d_{31}}{s_{11}^E + s_{12}^E} = e_{31} + e_{33}\frac{s_{13}^E}{s_{11}^E + s_{12}^E}$$

On obtient alors l'égalité suivante :

$$T_1 = T_1 = \frac{c_{13}^E}{c_{33}^E}e_{33}E_3 - e_{31}E_3 = e_{31,eff}E_3$$

)

L'étape 150 de calcul du coefficient piézoélectrique effectif est réalisée selon l'équation :

$$e31eff = (T1/E3)$$

où T1 est la contrainte et E3 le champ électrique appliqué, à une température T préalablement définie, T1 étant calculé par application de la formule de Stoney.

Ainsi, on applique le champ E3 le long d'un cycle électrique sur une électrode assez allongée dans une direction. On mesure la contrainte T1 par chaque valeur du champ E3 via une mesure de courbure par HRXRD (abréviation de High Resolution X-Ray Diffraction pour diffraction des rayons X haute résolution). Puis on trace T1 en fonction de E3 et on ajuste la pente pour obtenir le coefficient e31eff.

La figure 8 représente le principe de détermination d'un rayon de courbure pour la détermination d'un coefficient piézoélectrique transversal effectif du procédé selon l'invention. Cette figure vise à illustrer le principe global de détermination du rayon de courbure. L'échantillon 11 est placé entre une électrode inférieure et une électrode supérieure, h représentant l'épaisseur du substrat. Plusieurs points de mesure sont placés sur l'électrode supérieure de l'échantillon 11 (il y en a cinq sur l'exemple de la figure 8, il pourrait y en avoir trois, quatre ou même plus que cinq). L'équation en haut de la figure 8 donne la contrainte T1 en fonction du rayon de courbure R et de la raideur S. La courbe de basculement (ou rocking curve) du substrat silicium est mesurée en cinq points (dans l'exemple illustré). Les deux graphes inférieurs représentent la courbe de basculement. Il est ainsi possible de déterminer le rayon de courbure R via l'équation notée au bas de la figure 8.

Enfin, si on connait les constantes élastiques, à partir des coefficients d3,eff et e31eff, on peut calculer les coefficient d33 et d31.

Il apparaîtra plus généralement à l'Homme du métier que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'Homme du métier se basant sur ses connaissances générales.

## Revendications

**1.** Dispositif (10) de détermination d'au moins un coefficient piézoélectrique transversal (e31eff) effectif sur un film mince d'un matériau d'un échantillon (11), comprenant:

- une source (12) de rayons X incidents (13) sur l'échantillon (11);
- un détecteur (14) de rayons X diffractés (15) par l'échantillon (11);
- un dispositif de positionnement (16) de la source (12) de rayons X et du détecteur (14) de rayons X par rapport à l'échantillon (11);
- une source de tension électrique (17) en contact avec l'échantillon (11);
- un dispositif de commande (18) de la source de tension électrique (17) de sorte à appliquer un champ électrique à l'échantillon (11) pendant un cycle électrique, le champ électrique générant une déformation de l'échantillon et une contrainte sur l'échantillon ;
- un dispositif de mesure (19) d'un pic de diffraction des rayons X en fonction du champ électrique appliqué à l'échantillon (11) pendant le cycle électrique ;
- un dispositif de traitement (20) configuré pour déterminer le coefficient piézoélectrique transversal par l'intermédiaire de la détermination d'un rayon de courbure de l'échantillon à partir du pic de diffraction mesuré.

**2.** Dispositif de détermination (10) selon la revendication 1, comprenant en outre un monochromateur (121) et un collimateur (122) couplés à la source (12) de rayons X.

**3.** Dispositif de détermination (10) selon la revendication 1 ou 2, dans lequel le détecteur (14) de rayons X est un ensemble formé par un collimateur et un détecteur 0D ou un détecteur 1D ou 2D à pixel hybride.

**4.** Dispositif de détermination (10) selon l'une quelconque des revendications 1 à 3, dans lequel le dispositif de positionnement (16) est un goniomètre comprenant au moins un premier bras mobile en rotation autour de l'échantillon (11) et un deuxième bras, distinct du premier bras, mobile en rotation autour de l'échantillon (11), la source (12) de rayons X étant positionnée sur le premier bras et le détecteur (14) de rayons X étant positionné sur le deuxième bras.

**5.** Dispositif de détermination (10) selon l'une quelconque des revendications 1 à 4, comprenant en outre une chambre thermique dans laquelle l'échantillon (11) est positionné.

**6.** Dispositif de détermination (10) selon l'une quelconque des revendications 1 à 5, configuré en outre pour déterminer un coefficient piézoélectrique longitudinal effectif (d33eff), dans lequel le dispositif de traitement (20) est configuré pour déterminer un paramètre de maille (d-spacing) du matériau à partir du pic de diffraction mesuré et de calculer le coefficient piézoélectrique longitudinal effectif (d33eff).

**7.** Dispositif de détermination (10) selon l'une quelconque des revendications 1 à 6 dans lequel le dispositif de traitement (20) est configuré pour déterminer le rayon de courbure par une courbe de basculement mesurée en une pluralité de points sur l'échantillon.

8. Procédé de détermination d'au moins un coefficient piézoélectrique transversal (e31eff) effectif sur un film mince d'un matériau d'un échantillon, comprenant les étapes suivantes :

   - application (étape 100) d'un champ électrique à l'échantillon pendant un cycle électrique ;
   - émission (étape 110) de rayons X incidents sur l'échantillon ;
   - détection (étape 120) de rayons X diffractés par l'échantillon ;
   - mesure (étape 130) d'un pic de diffraction des rayons X en fonction du champ électrique appliqué à l'échantillon pendant le cycle électrique ;
   - détermination (étape 140) d'un rayon de courbure de l'échantillon à partir du pic de diffraction mesuré
   - calcul (étape 150) du coefficient piézoélectrique transversal effectif.

9. Procédé de détermination selon la revendication 8, dans lequel l'étape (100) d'application d'un champ électrique comprend l'application d'une pluralité de valeurs de champ électrique, l'une parmi la pluralité de valeurs de champ électrique étant préférentiellement égale à zéro.

10. Procédé selon l'une quelconque des revendications 8 ou 9 dans lequel le procédé vise à déterminer en outre un coefficient piézoélectrique longitudinal effectif (d33eff) et le procédé comprend en outre les étapes suivantes :

    - détermination d'un paramètre de maille du matériau à partir du pic de diffraction mesuré,
    - Calcul (étape 150) du coefficient piézoélectrique longitudinal effectif .

11. Procédé de détermination selon la revendication 10, dans lequel le paramètre de maille du matériau est déterminé par application de la loi de Bragg selon laquelle 2 * d-spacing * sin(θ) = λ, où λ est la longueur d'onde du faisceau de rayons X, θ est l'angle entre les rayons X incidents et les rayons X diffractés et d-spacing est le paramètre de maille.

12. Procédé de détermination selon la revendication 11, dans lequel l'étape (150) de calcul du coefficient piézoélectrique effectif longitudinal est réalisée selon l'équation :

$$d_{33,\,eff} = (S_3/E_3)$$

où S3 est la déformation et E3 le champ électrique appliqué, à une température T préalablement définie, S3 étant calculé selon l'équation S3 = {d-spacing(E) -d-spacing(E=0)} / d-spacing(E=0), où d-spacing(E) est le paramètre de maille avec application d'un champ électrique E.

13. Procédé de détermination selon l'une des revendications 8 ou 9, dans lequel le rayon de courbure est déterminé par une courbe de basculement mesurée en une pluralité de points sur l'échantillon.

14. Procédé de détermination selon la revendication 13, dans lequel l'étape (150) de calcul du coefficient piézoélectrique transversal effectif est réalisée selon l'équation :

$$e_{31,\,eff} = (T_1/E_3)$$

où T1 est la contrainte et E3 le champ électrique appliqué, à une température T préalablement définie, T1 étant calculé par application de la formule de Stoney.

**Patentansprüche**

1. Vorrichtung (10) zur Bestimmung mindestens eines effektiven transversalen piezoelektrischen Koeffizienten (e31eff) eines dünnen Films aus einem Material einer Probe (11), die Folgendes umfasst:

   - eine Quelle (12) für Röntgenstrahlen (13), die auf die Probe (11) auftreffen;
   - einen Detektor (14) für Röntgenstrahlen (15), die an der Probe (11) gebeugt werden;
   - eine Vorrichtung (16) zum Positionieren der Röntgenstrahlenquelle (12) und des Röntgenstrahlendetektors (14) in Bezug auf die Probe (11);
   - eine elektrische Spannungsquelle (17) in Kontakt mit der Probe (11);

- eine Vorrichtung (18) zum Steuern der elektrischen Spannungsquelle (17), um während eines elektrischen Zyklus ein elektrisches Feld an die Probe (11) anzulegen, wobei das elektrische Feld eine Verformung der Probe und eine Belastung auf der Probe erzeugt;
- eine Vorrichtung (19) zum Messen eines Röntgenstrahlenbeugungspeaks als Funktion des elektrischen Feldes, das während des elektrischen Zyklus an die Probe (11) angelegt wird;
- eine Verarbeitungsvorrichtung (20), konfiguriert zum Bestimmen des transversalen piezoelektrischen Koeffizienten durch Bestimmen eines Krümmungsradius der Probe auf der Basis des gemessenen Beugungspeaks.

2. Bestimmungsvorrichtung (10) nach Anspruch 1, die ferner einen Monochromator (121) und einen Kollimator (122) umfasst, die mit der Röntgenstrahlenquelle (12) gekoppelt sind.

3. Bestimmungsvorrichtung (10) nach Anspruch 1 oder 2, wobei der Röntgenstrahlendetektor (14) eine Baugruppe ist, die aus einem Kollimator und einem 0D-Detektor oder einem 1D- oder 2D-Hybridpixel-Detektor gebildet ist.

4. Bestimmungsvorrichtung (10) nach einem der Ansprüche 1 bis 3, wobei die Positionierungsvorrichtung (16) ein Goniometer ist, das mindestens einen um die Probe (11) drehbeweglichen ersten Arm und einen vom ersten Arm verschiedenen und um die Probe (11) drehbeweglichen zweiten Arm umfasst, wobei die Röntgenstrahlenquelle (12) auf dem ersten Arm positioniert ist und der Röntgenstrahlendetektor (14) auf dem zweiten Arm positioniert ist.

5. Bestimmungsvorrichtung (10) nach einem der Ansprüche 1 bis 4, die ferner eine Wärmekammer umfasst, in der die Probe (11) positioniert ist.

6. Bestimmungsvorrichtung (10) nach einem der Ansprüche 1 bis 5, ferner konfiguriert zum Bestimmen eines effektiven longitudinalen piezoelektrischen Koeffizienten (d33eff), wobei die Verarbeitungsvorrichtung (20) konfiguriert ist zum Bestimmen eines Gitterparameters (d-spacing) des Materials auf der Basis des gemessenen Beugungspeaks und zum Berechnen des effektiven longitudinalen piezoelektrischen Koeffizienten (d33eff).

7. Bestimmungsvorrichtung (10) nach einem der Ansprüche 1 bis 6, wobei die Verarbeitungsvorrichtung (20) zum Bestimmen des Krümmungsradius durch eine an einer Vielzahl von Punkten auf der Probe gemessene Kippkurve konfiguriert ist.

8. Verfahren zum Bestimmen mindestens eines effektiven transversalen piezoelektrischen Koeffizienten (e31eff) eines dünnen Films aus einem Material einer Probe, das die folgenden Schritte umfasst:

- Anlegen (Schritt 100) eines elektrischen Feldes an die Probe während eines elektrischen Zyklus;
- Aussenden (Schritt 110) von Röntgenstrahlen, die auf die Probe auftreffen;
- Detektieren (Schritt 120) von Röntgenstrahlen, die von der Probe gebeugt werden;
- Messen (Schritt 130) eines Röntgenstrahlenbeugungspeaks als Funktion des während des elektrischen Zyklus an die Probe angelegten elektrischen Feldes;
- Bestimmen (Schritt 140) eines Krümmungsradius der Probe auf der Basis des gemessenen Beugungspeaks;
- Berechnen (Schritt 150) des effektiven transversalen piezoelektrischen Koeffizienten.

9. Bestimmungsverfahren nach Anspruch 8, wobei der Schritt (100) des Anlegens eines elektrischen Feldes das Anlegen einer Vielzahl von Werten des elektrischen Feldes umfasst, wobei einer der Vielzahl von Werten des elektrischen Feldes vorzugsweise Null ist.

10. Verfahren nach einem von Anspruch 8 oder 9, wobei das Verfahren darauf abzielt, zusätzlich einen effektiven longitudinalen piezoelektrischen Koeffizienten (d33eff) zu bestimmen, und das Verfahren ferner die folgenden Schritte umfasst:

- Bestimmen eines Gitterparameters des Materials auf der Basis des gemessenen Beugungspeaks,
- Berechnen (Schritt 150) des effektiven longitudinalen piezoelektrischen Koeffizienten.

11. Bestimmungsverfahren nach Anspruch 10, wobei der Gitterparameter des Materials durch Anwenden des Bragg'schen Gesetzes bestimmt wird, gemäß dem $2 * d\text{-spacing} * \sin(\theta) = \lambda$, wobei $\lambda$ die Wellenlänge des Röntgenstrahls ist, $\theta$ der Winkel zwischen den einfallenden und den gebeugten Röntgenstrahlen ist und d-spacing der Gitterparameter ist.

**12.** Bestimmungsverfahren nach Anspruch 11, wobei der Schritt (150) des Berechnens des effektiven longitudinalen piezoelektrischen Koeffizienten gemäß der folgenden Gleichung durchgeführt wird:

$$d_{33,\,\text{eff}} = (S_3/E_3)$$

wobei S3 die Verformung und E3 das angelegte elektrische Feld ist, bei einer zuvor definierten Temperatur T, wobei S3 gemäß der Gleichung S3 = {d-spacing(E) - d-spacing(E=0)} / d-spacing(E=0) berechnet wird, wobei d-spacing(E) der Gitterparameter bei Anlegen eines elektrischen Feldes E ist.

**13.** Bestimmungsverfahren nach Anspruch 8 oder 9, wobei der Krümmungsradius durch eine an einer Vielzahl von Punkten auf der Probe gemessene Kippkurve bestimmt wird.

**14.** Bestimmungsverfahren nach Anspruch 13, wobei der Schritt (150) des Berechnens des effektiven transversalen piezoelektrischen Koeffizienten gemäß der folgenden Gleichung durchgeführt wird:

$$e_{31,\,\text{eff}} = (T_1/E_3)$$

wobei T1 die Belastung und E3 das angelegte elektrische Feld ist, bei einer zuvor definierten Temperatur T, wobei T1 durch Anwenden der Stoney-Formel berechnet wird.

**Claims**

**1.** A device (10) for determining at least one effective transverse piezoelectric coefficient (e31eft) of a thin film of a material of a sample (11), comprising:

- a source (12) of x-rays (13) incident on the sample (11);
- a detector (14) of x-rays (15) diffracted by the sample (11);
- a device (16) for positioning the x-ray source (12) and the x-ray detector (14) with respect to the sample (11);
- a voltage source (17) making contact with the sample (11);
- a device (18) for controlling the voltage source (17) so as to apply an electric field to the sample (11) during an electrical cycle, the electric field generating a strain of the sample and a stress on the sample;
- a device (19) for measuring a diffraction peak of the x-rays as a function of the electric field applied to the sample (11) during the electrical cycle;
- a processing device (20) configured to determine the transverse piezoelectric coefficient via determination of a radius of curvature of the sample on the basis of the measured diffraction peak.

**2.** The determining device (10) according to claim 1, further comprising a monochromator (121) and a collimator (122) that are coupled to the x-ray source (12).

**3.** The determining device (10) according to claim 1 or 2, wherein the x-ray detector (14) is an assembly formed by a collimator and a 0D detector or a 1D or 2D hybrid-pixel detector.

**4.** The determining device (10) according to any one of claims 1 to 3, wherein the positioning device (16) is a goniometer comprising at least a first arm that is rotatable around the sample (11) and a second arm, distinct from the first arm, that is rotatable around the sample (11), the x-ray source (12) being positioned on the first arm and the x-ray detector (14) being positioned on the second arm.

**5.** The determining device (10) according to any one of claims 1 to 4, further comprising a thermal chamber in which the sample (11) is positioned.

**6.** The determining device (10) according to any one of claims 1 to 5, further configured to determine an effective longitudinal piezoelectric coefficient (d33eff), wherein the processing device (20) is configured to determine a lattice parameter (d-spacing) of the material on the basis of the measured diffraction peak and to compute the effective longitudinal piezoelectric coefficient (d33eff).

7. The determining device (10) according to any one of claims 1 to 6, wherein the processing device (20) is configured to determine the radius of curvature via a rocking curve measured at a plurality of points on the sample.

8. A method for determining at least one effective transverse piezoelectric coefficient (e31eff) of a thin film of a material of a sample, comprising the following steps:

   - applying (step 100) an electric field to the sample during an electrical cycle;
   - emitting (step 110) x-rays incident on the sample;
   - detecting (step 120) x-rays diffracted by the sample;
   - measuring (step 130) a diffraction peak of the x-rays as a function of the electric field applied to the sample during the electrical cycle;
   - determining (step 140) a radius of curvature of the sample on the basis of the measured diffraction peak;
   - computing (step 150) the effective transverse piezoelectric coefficient.

9. The determining method according to claim 8, wherein the step (100) of applying an electric field comprises applying a plurality of electric-field values, one among the plurality of electric-field values preferably being equal to zero.

10. The method according to any one of claims 8 or 9, wherein the method further aims to determine an effective longitudinal piezoelectric coefficient (d33eff) and the method further comprises the following steps

   - determining a lattice parameter of the material on the basis of the measured diffraction peak,
   - computing (step 150) the effective longitudinal piezoelectric coefficient.

11. The determining method according to claim 10, wherein the lattice parameter of the material is determined by applying Bragg's law according to which $2 * \text{d-spacing} * \sin(\theta) = \lambda$, where $\lambda$ is the wavelength of the x-ray beam, $\theta$ is the angle between the incident x-rays and the diffracted x-rays and d-spacing is the lattice parameter.

12. The determining method according to claim 11, wherein the step (150) of computing the effective longitudinal piezoelectric coefficient is carried out according to the equation:

$$d_{33, \text{eff}} = (S_3/E_3)$$

where $S_3$ is the strain and $E_3$ the applied electric field, at a temperature T defined beforehand, $S_3$ being computed according to the equation $S_3 = \{\text{d-spacing}(E) - \text{d-spacing}(E=0)\} / \text{d-spacing}(E=0)$, where d-spacing(E) is the lattice parameter with application of an electric field E.

13. The determining method according to any one of claims 8 or 9, wherein the radius of curvature is determined via a rocking curve measured at a plurality of points on the sample.

14. The determining method according to claim 13, wherein the step (150) of computing the effective transverse piezoelectric coefficient is carried out according to the equation:

$$e_{31, \text{eff}} = (T_1/E_3)$$

where $T_1$ is the stress and $E_3$ the applied electric field, at a temperature T defined beforehand, $T_1$ being computed by applying Stoney's equation.

FIG. 1

FIG. 2

FIG. 3

FIG. 4

FIG. 5

FIG. 6

FIG. 7

$$T_1 h_f = \frac{h^2}{6(S_{11}^{Si} + S_{12}^{Si})R}$$

$$\frac{1}{R} = \frac{\tan(\Delta\omega)}{\Delta x} \approx \frac{\Delta\omega}{\Delta x}$$

FIG. 8

**EP 4 095 934 B1**

## RÉFÉRENCES CITÉES DANS LA DESCRIPTION

**Documents brevets cités dans la description**

- US 2013207513 A